(19) Europäisches Patentamt

European Patent Office

Office européen des brevets

(11) **EP 0 824 798 B1**

(12) **FASCICULE DE BREVET EUROPEEN**

(45) Date de publication et mention
de la délivrance du brevet:
**09.06.1999  Bulletin 1999/23**

(21) Numéro de dépôt: **96919852.2**

(22) Date de dépôt: **02.05.1996**

(51) Int Cl.⁶: **H04B 3/21**, H03H 21/00

(86) Numéro de dépôt international:
**PCT/FR96/00664**

(87) Numéro de publication internationale:
**WO 96/35266 (07.11.1996 Gazette 1996/49)**

(54) **FILTRAGE ADAPTATIF A SOUS-BANDES**

ADAPTIVE TEILBANDFILTRIERUNG

ADAPTIVE SUB-BAND FILTERING

(84) Etats contractants désignés:
**DE GB IT**

(30) Priorité: **05.05.1995  FR 9505410**

(43) Date de publication de la demande:
**25.02.1998  Bulletin 1998/09**

(73) Titulaires:
• **FRANCE TELECOM**
**75015 Paris (FR)**
• **Etablissement Public Télédiffusion de France**
**75015 Paris (FR)**

(72) Inventeurs:
• **DE COURVILLE, Marc**
**F-75014 Paris (FR)**
• **DUHAMEL, Pierre**
**F-92350 Le Plessis-Robinson (FR)**
• **PALICOT, Jacques**
**F-35000 Rennes (FR)**
• **MADEC, Philippe**
**F-35700 Rennes (FR)**

(74) Mandataire: **Fréchède, Michel**
**Cabinet Plasseraud**
**84, rue d'Amsterdam**
**F-75440 Paris Cédex 09 (FR)**

(56) Documents cités:
**US-A- 5 329 587**

• **ICASSP 88: 1988 INTERNATIONAL CONFERENCE ON ACOUSTICS, SPEECH AND SIGNAL PROCESSING, vol. 3, 11 - 14 Avril 1988, NY, USA, pages 1572-1575, XP002012917 GILLOIRE ET AL: "Adaptive filtering in sub-bands"**
• **PROCEEDINGS OF THE IEEE-SP INTERNATIONAL SYMPOSIUM TIME-FREQUENCY AND TIME-SCALE ANALYSIS, 4 - 6 Octobre 1992, NY, USA, pages 291-294, XP002012918 OCHI H., YAMADA Y., KIYA H.: "A new class of subband adaptive filter using alias-free maximally decimated DFT-bank"**

**Description**

La présente invention concerne un procédé de filtrage adaptatif, par critère d'optimisation pondéré, d'un signal numérique décomposé en sous-bandes de fréquences, et le dispositif de filtrage correspondant.

Dans le domaine du traitement du signal numérique, les techniques du filtrage adaptatif interviennent lorsqu'on souhaite réaliser, simuler ou modéliser un système de transmission de ce signal dont les caractéristiques évoluent dans le temps.

A titre d'exemple non limitatif, on considérera deux applications fondamentales des techniques du filtrage adaptatif.

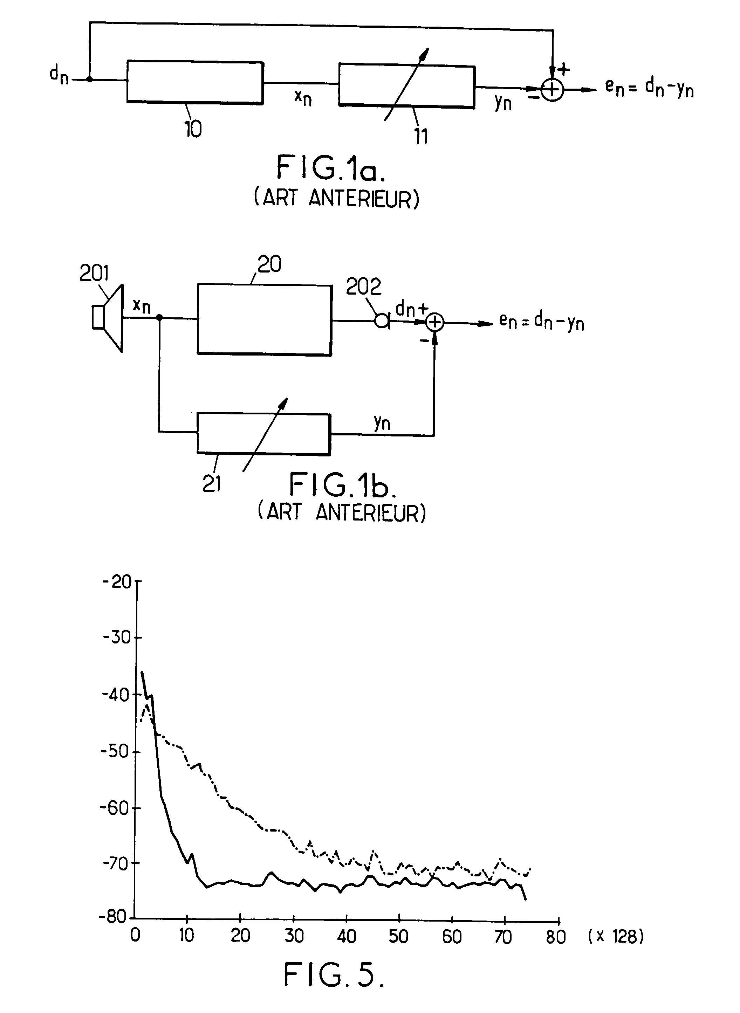

La première application relative à la technique d'égalisation adaptative est représentée de façon schématique en figure 1a. Un signal numérique d'origine, constitué par une succession d'échantillons, est transmis sous forme d'un signal numérique transmis succession d'échantillons $x_n$ par l'intermédiaire d'un canal de transmission 10 quelconque, avec introduction de certaines distorsions. On suppose, dans un tel cas, que les distorsions ou déformations subies par le signal d'origine $d_n$, lors de la transmission, peuvent être assimilées à un filtrage linéaire. Un dispositif égaliseur 11 permet de modéliser, de manière adaptative, un filtre dont la fonction de transfert est l'inverse de celle du canal de transmission 10, de façon que le signal $y_n$ délivré par le filtre constitué par le dispositif égaliseur 11 soit le plus proche possible du signal d'origine $d_n$. Dans ces conditions, l'adaptation des coefficients du filtre constitué par le dispositif égaliseur 11 permet de rendre minimale l'énergie de l'erreur de modélisation, $e_n$, égale à la différence entre le signal numérique d'origine $d_n$ et le signal numérique transmis $y_n$.

La deuxième application se rapporte à l'annulation d'écho acoustique et est représentée de façon schématique en figure 1b. Dans le cas d'une situation de communication téléphonique de type "mains libres", un premier locuteur, se trouvant dans une salle 20, parle dans un microphone 202 situé dans la salle 20, et reçoit un signal de parole $x_n$ provenant d'un deuxième locuteur à distance par l'intermédiaire d'un haut-parleur 201 également situé dans la salle 20. On suppose que la salle 20 agit sur ce signal de parole reçu $x_n$ comme un filtre linéaire. Ainsi, le microphone 202 capte un signal $d_n$ issu du signal de parole $x_n$ après filtrage par la salle 20. Ce signal $d_n$ est donc renvoyé au deuxième locuteur à distance sous forme d'un écho à ses propres paroles. Afin de supprimer cet écho indésirable, on cherche à modéliser, au moyen d'un dispositif annuleur d'écho 21, le filtre constitué par la salle, de façon que le signal $y_n$ délivré par le dispositif annuleur d'écho 21 soit le plus proche possible du signal d'écho $d_n$. De même que dans la première application, l'adaptation des coefficients du filtre constitué par le dispositif annuleur d'écho 21 permet de rendre l'énergie de l'erreur de modélisation, $e_n = d_n - y_n$, minimale.

Le processus de filtrage adaptatif implique donc la mise en oeuvre de filtres à coefficients variables dans le temps. Les variations pour adaptation des valeurs de ces coefficients sont établies grâce à un critère d'optimisation et réalisées conformément à un processus ou algorithme d'adaptation.

Parmi la grande variété de critères et d'algorithmes d'adaptation susceptibles d'être utilisés, le critère de minimisation de l'erreur quadratique moyenne associé à l'algorithme du gradient (*Least Mean Square algorithm, LMS* en vocable anglo-saxon pour algorithme des moindres carrés) est le plus souvent utilisé, en raison du bon compromis que celui-ci offre entre simplicité de mise en oeuvre et efficacité de traitement.

Toutefois, ce mode de traitement présente une vitesse de convergence relativement lente, ce qui constitue un inconvénient majeur pour bon nombre d'applications. Afin de remédier à cet inconvénient, des versions modifiées de l'algorithme LMS ont été proposées.

En particulier, une première approche a consisté, afin de réduire la complexité de calcul et d'augmenter la vitesse de convergence de l'algorithme d'adaptation, à réaliser le filtrage adaptatif en sous-bandes de fréquences. Le mode opératoire correspondant consiste à subdiviser le signal d'entrée et le signal de sortie du système à modéliser en sous-bandes de fréquences adjacentes, à sous-échantillonner chaque signal en sous-bande, et à appliquer à ce signal le processus de filtrage adaptatif. L'opération de sous-échantillonnage a pour objet d'obtenir une meilleure efficacité de calcul que dans le cas d'un processus de filtrage pleine bande, et le traitement dans chaque sous-bande peut permettre d'améliorer la vitesse de convergence du processus d'adaptation, en raison du fait qu'il est possible d'optimiser la vitesse de convergence de celui-ci dans chacune des sous-bandes.

Toutefois, en raison du chevauchement des spectres de fréquence en sous-bandes inhérent aux bancs de filtres utilisés, il apparaît, au niveau du signal de sortie, des composantes indésirables de repliement du spectre de fréquence aux frontières entre sous-bandes, lesquelles dégradent les performances du processus d'adaptation. En particulier, lorsque l'opération de sous-échantillonnage est réalisée par décimation à la fréquence de décimation critique, c'est-à-dire lorsque le rapport de sous-échantillonnage est égal au nombre de sous-bandes, les composantes indésirables dues au phénomène de repliement du spectre de fréquence apparaissent gênantes.

Diverses solutions visant, d'une part, à éviter le phénomène de repliement du spectre, et, d'autre part, à réduire la complexité des calculs ont été proposées.

Parmi celles-ci, A. GILLOIRE et M.VETTERLI ont, dans une publication intitulée *"Adaptive Filtering in Subbands with Critical Sampling : Analysis, Experiments, and Application to Acoustic Echo Cancellation",* IEEE Transactions on Signal Processing, Vol.40, N°8, août 1992, décrit un algorithme de filtrage adaptatif en sous-bandes, lequel a pour objet essentiel une réduction de la complexité de calcul, une augmentation de la vitesse de convergence du processus d'adaptation pouvant, le cas échéant, être recherchée.

La solution proposée consiste à reporter le processus de filtrage adaptatif en sous-bandes de fréquences.

Toutefois, afin de permettre la mise en oeuvre d'une solution exacte, il est nécessaire d'effectuer en outre un filtrage inter-bande en raison de l'existence d'une intercorrélation entre les spectres de fréquence de chacune des sous-bandes constituées. Ainsi, pour une subdivision en N sous-bandes, il est nécessaire de mettre en oeuvre $N^2$ filtres, de longueur N fois plus faible, ce qui ne réduit donc aucunement le volume de calcul global. En outre, en raison de l'intercorrélation précitée entre les spectres de fréquence de chacune des sous-bandes, les coefficients de filtrage des filtres utilisés sont liés et le filtrage adaptatif lui-même est très difficile à mettre en oeuvre.

Dans une solution simplifiée proposée par la publication précitée, et en raison des inconvénients précités, une approximation a donc été introduite, cette approximation consistant à ne conserver que l'interaction due au recouvrement partiel entre sous-bandes adjacentes.

Afin de remédier aux inconvénients précités, une étude intitulée *"Adaptive Echo Cancellation for Speech Signals"* publiée par M.MOHAN SONDHI et WALTER KELLERMANN, AT&T Bell Laboratories, Murray Hill, New Jersey, USA, Advances in Speech Signal Processing, S.FURUI & M.M. SONDHI, M.Dekker Inc. (1992) a montré la possibilité de minorer l'effet des inconvénients précités pourvu qu'une quantité d'information supérieure à la quantité d'information obtenue par sous-échantillonnage critique, rapport de sous-échantillonnage égal au nombre de sous-bandes, soit conservée. Un tel mode opératoire présente des problèmes et augmente en conséquence le volume de calcul en raison de la redondance, nécessaire, de l'information traitée.

Enfin, le document US-A-5 329 587 décrit une succession d'étapes consistant à décomposer un signal de référence et un signal d'erreur en sous-bandes, et à engendrer des coefficients de pondération pour chaque sous-bande.

Ces coefficients de pondération sont ensuite transformés dans le domaine fréquentiel, accumulés et retransformés dans le domaine temporel pour obtenir des coefficients d'un filtre à large bande programmable. Le signal de référence est filtré au moyen de ce filtre à large bande pour engendrer un signal perturbateur estimé, lequel est soustrait du signal d'origine, contenant le signal perturbateur, et atténuer ou supprimer ainsi ce dernier. Un tel processus apparaît complexe en raison notamment du processus de retransformation des coefficients accumulés dans le domaine temporel.

Un objet de la présente invention est la mise en oeuvre d'un procédé et d'un dispositif de filtrage adaptatif d'un signal numérique décomposé en sous-bandes de fréquences, permettant d'optimiser la vitesse de convergence du processus d'adaptation, sans toutefois augmenter la complexité de calcul mise en oeuvre.

Un autre objet de la présente invention est en outre la mise en oeuvre d'un procédé et d'un dispositif de filtrage adaptatif d'un signal numérique décomposé en sous-bandes de fréquences, dans lesquels l'optimisation de la vitesse de convergence est obtenue par un critère pondéré d'erreur quadratique moyenne minimale des signaux d'erreur en sous-bande.

Un autre objet de la présente invention est enfin la mise en oeuvre d'un procédé et d'un dispositif de filtrage adaptatif d'un signal numérique décomposé en sous-bandes de fréquences dans lesquels le phénomène de repliement de spectre peut être occulté, grâce à la mise en oeuvre du processus de filtrage adaptatif dans le domaine temporel.

Le procédé et le dispositif de filtrage adaptatif d'un signal numérique transmis, objets de la présente invention, ce signal numérique transmis étant constitué par une succession d'échantillons ($x_n$) représentative d'un signal d'origine ($d_n$) soumis à un phénomène de distorsion après transmission par l'intermédiaire d'un canal de transmission sont remarquables en ce que ceux-ci consistent à respectivement permettent de soumettre le signal numérique transmis ($x_n$) à un filtrage adaptatif de fonction de transfert ($W^*$) pour obtenir un signal numérique transmis filtré succession d'échantillons ($y_n$), engendrer un signal d'erreur ($e_n$) pour chaque échantillon considéré, différence algébrique entre le signal numérique d'origine ($d_n$) et le signal numérique transmis filtré ($y_n$), soumettre le signal d'erreur ($e_n$) à une subdivision par décomposition orthogonale en un nombre déterminé (N) de sous-bandes de fréquences de largeur déterminée, pour engendrer, pour chaque sous-bande, un signal d'erreur en sous-bande, soumettre chaque signal d'erreur en sous-bande à un sous-échantillonnage par décimation dans un rapport (N) égal au nombre de sous-bandes, pour obtenir un ensemble de signaux d'erreur en sous-bande sous échantillonnés ($e_{i,k}$), où i désigne le rang de la sous-bande considérée, i ∈ [0, N-1], soumettre l'ensemble des signaux d'erreur en sous-bande sous-échantillonnés ($e_{i,k}$) à une pondération spécifique de coefficient ($\lambda_i$) pour engendrer des signaux d'erreur en sous-bande sous-échantillonnés pondérés ($\lambda_i.e_{i,k}$), soumettre en outre le signal numérique transmis ($x_n$) à une subdivision en un même nombre déterminé (N) de sous-bandes pour engendrer une pluralité de composantes en sous-bande ($x_{i,n}$) de signal numérique transmis, établir une fonction d'adaptation ($\Delta W^*$) de la fonction de transfert ($W^*$) du filtre adaptatif comme la somme du produit de chaque composante en sous-bande conjuguée du signal numérique transmis et du signal d'erreur en sous-bande sous-échantillonné pondéré correspondant ($\lambda_i.e_{i,k}$) affectée d'un pas d'adaptation ($\mu$), ce qui permet pour un critère global d'erreur minimale des signaux d'erreur en sous-bande sous-échantillonnés pondérés, d'optimiser indépendamment la vitesse de convergence du filtre adaptatif dans chaque sous-bande, et, ainsi, la vitesse de convergence globale de ce dernier.

Le procédé et le dispositif de filtrage adaptatif objets de l'invention trouvent application aux techniques d'égalisation, ainsi que mentionné précédemment dans la description, ainsi qu'aux techniques de suppression d'échos, notamment de signaux de parole.

Ils seront mieux compris à la lecture de la description et à l'observation des dessins ci-après dans lesquels, outre la figure la relative à la technique d'égalisation d'un signal numérique et la figure 1b relative à la technique d'annulation d'écho connues de l'art antérieur,

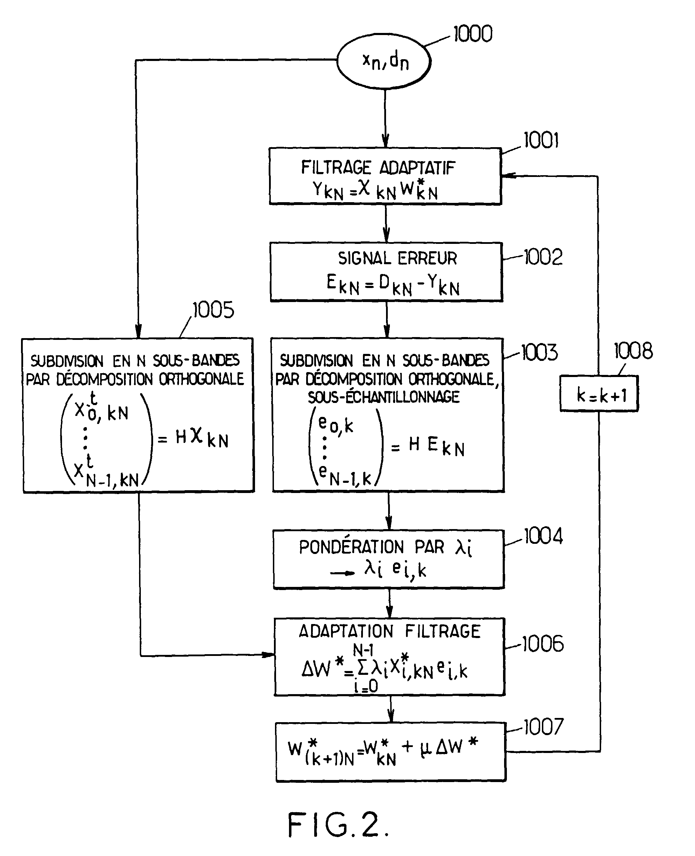

- la figure 2 représente, sous forme illustrative, un organigramme de l'ensemble des étapes de mise en oeuvre du procédé de filtrage adaptatif d'un signal numérique objet de la présente invention ;

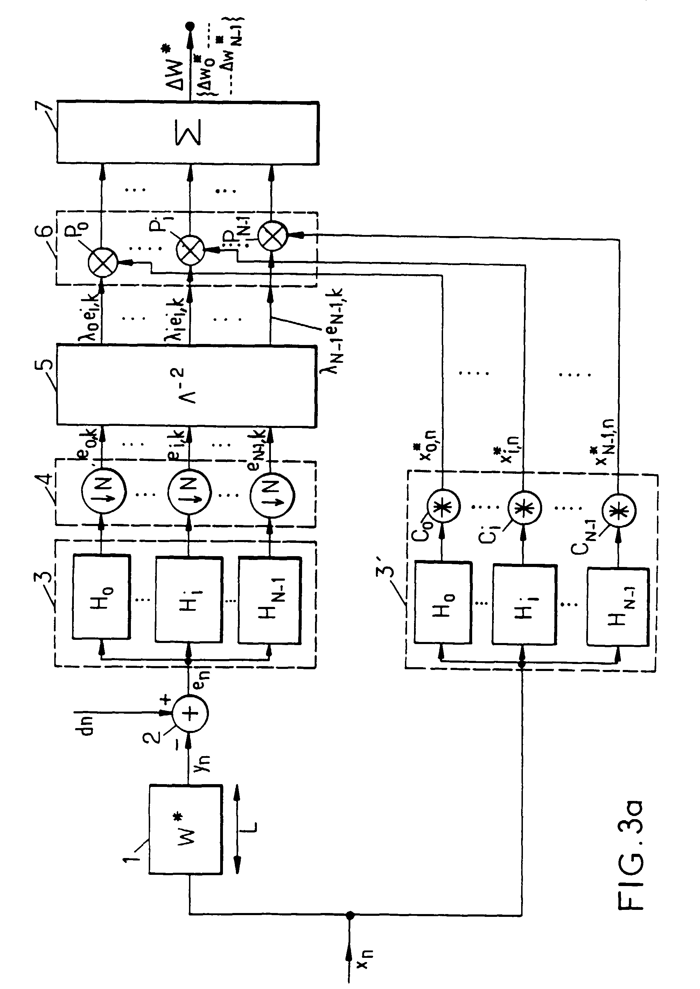

- la figure 3a représente, sous forme de schéma fonctionnel, un mode particulier de réalisation non limitatif d'un dispositif de filtrage adaptatif conforme à l'objet de la présente invention, dans le cas où, dans un but de simplification, le nombre de coefficients du filtre adaptatif mis en oeuvre est inférieur ou égal au nombre de sous-bandes de fréquences ;

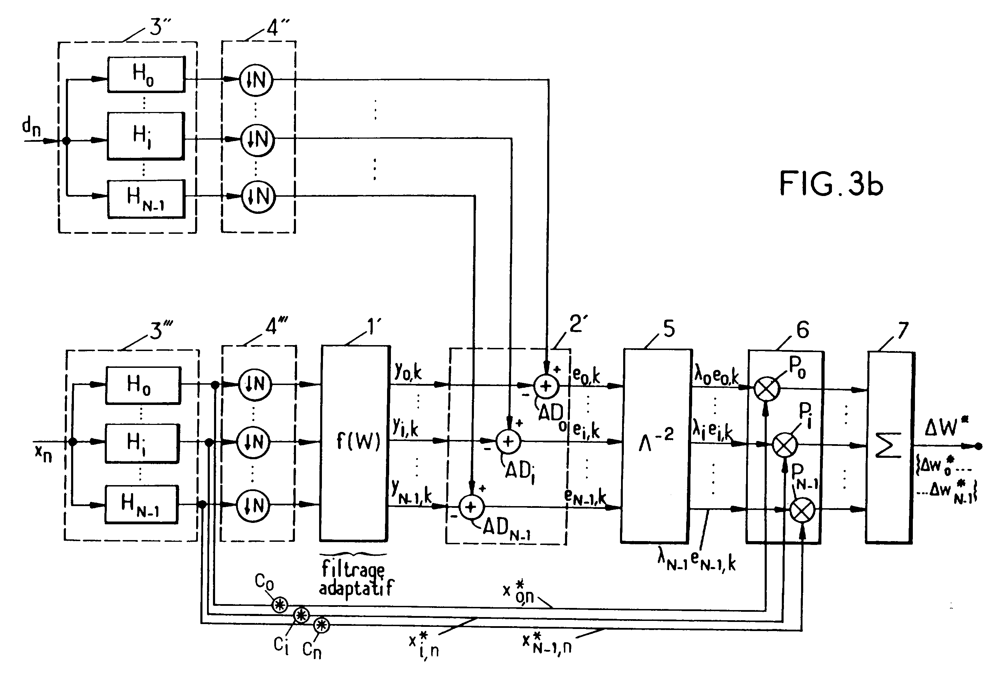

- la figure 3b représente, sous forme de schéma fonctionnel, une variante de réalisation du dispositif de la figure 3a dans lequel le filtre adaptatif est implanté en sous-bandes ;

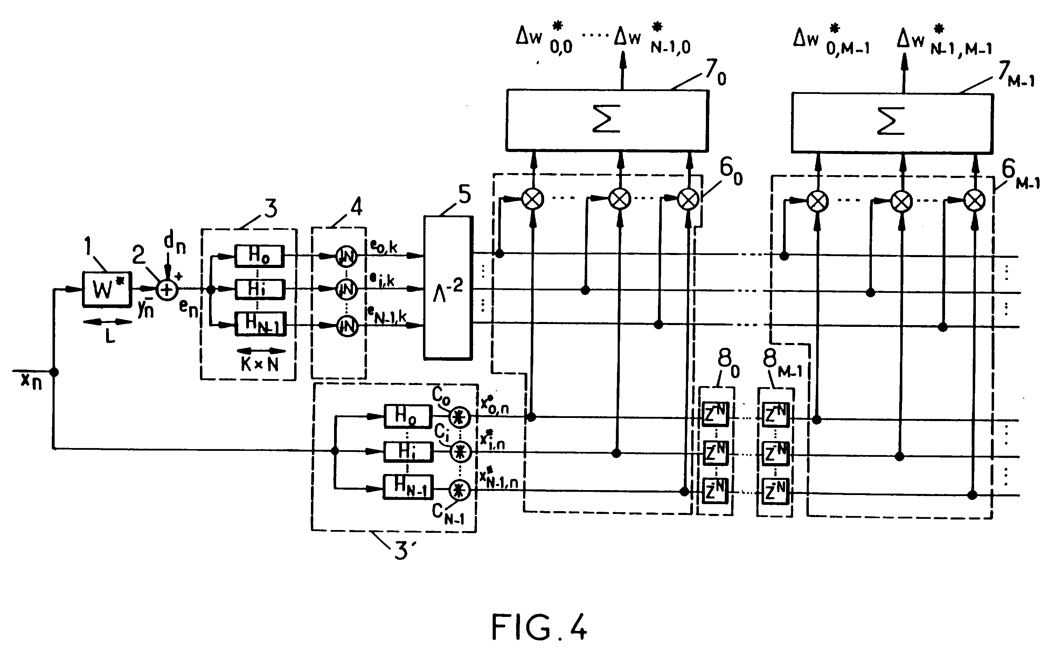

- la figure 4 représente, dans le cas général, sous forme de schéma fonctionnel, un mode particulier de réalisation non limitatif d'un dispositif de filtrage adaptatif conforme à l'objet de la présente invention, dans le cas où le nombre de coefficients du filtre adaptatif est un multiple entier du nombre de sous-bandes de fréquences ;
- la figure 5 représente un graphe illustrant un exemple de décroissance dans le temps de l'erreur de modélisation d'un canal de transmission dans le cas de la mise en oeuvre d'un processus d'adaptation LMS classique et d'un processus d'adaptation conforme à l'objet de la présente invention respectivement.

Une description plus détaillée du procédé de filtrage adaptatif d'un signal numérique transmis, conforme à l'objet de la présente invention, sera maintenant donnée en liaison avec la figure 2.

Dans toute la suite, les variables considérées seront supposées complexes, ce qui correspond au cas le plus général. Par convention, l'opérateur $(.)^t$ désigne l'opération de transposition, l'opérateur $(.)^*$ désigne l'opération de conjugaison, et l'opérateur $(.)^H$ l'opération de transconjugaison $((.)^t)^*$ au sens classique de ces termes dans la technique de traitement du signal.

En outre, les notations ci-après sont introduites :

$n =$ rang de chaque échantillon de tout signal numérique entrant dans la mise en oeuvre du procédé et du dispositif selon l'invention ;

$N =$ nombre de sous-bandes dans lequel la subdivision en sous-bandes est réalisée ;

$W_n =$ $(w_0, w_1 ..., w_j, ..., w_{L-1})^t$
fonction de transfert du filtre adaptatif pour l'échantillon de rang n, $w_j$ désignant le coefficient de rang j du filtre adaptatif, L la longueur en nombre de coefficients du filtre adaptatif ;

$X_n =$ $(x_n, x_{n-1}, ..., x_{n-KN+1})^t$
vecteur d'entrée du signal numérique transmis comportant KN composantes constituées par un bloc de KN échantillons successifs, K désignant un entier supérieur ou égal à 1 ;

$\chi_n =$ $(X_n, X_{n-1}, ..., X_{n-L+1})_{KNxL}$
matrice d'entrée de dimension KNxL, constituée par L vecteurs d'entrée du signal numérique transmis successifs ;

$D_n =$ $(d_n, d_{n-1}, ..., d_{n-KN+1})^t$
vecteur d'entrée du signal numérique d'origine comportant KN composantes constituées par un bloc de KN échantillons successifs ;

$E_n =$ $(e_n, e_{n-1}, ..., e_{n-KN+1})^t$
vecteur d'erreur comportant KN composantes ;

$H =$ $(H_0^t, ..., H_i^t, ..., H_{N-1}^t)^t$
matrice des coefficients de l'opérateur de subdivision en N sous-bandes, $H_i^t$ représentant un vecteur de KN coefficients associé à la sous-bande de rang i.

Comme représenté sur la figure 2, on considère à l'étape 1000 un signal numérique $x_n$ et le signal d'origine $d_n$ tels que définis précédemment dans le cadre de l'une ou l'autre des applications.

Le procédé objet de la présente invention consiste, à l'étape suivante 1001, à soumettre le signal $x_n$ à un filtrage adaptatif, $y_n$ désignant le signal obtenu après filtrage. L'opération de filtrage permet d'obtenir un vecteur $Y_n = (y_n, y_{n-1}, ..., y_{n-KN+1})^t$, vérifiant la relation $Y_{kN} = \chi_{kN}.W^*_{kN}$. Dans cette relation, k est un entier positif désignant la $k^{ème}$ itération du processus d'adaptation tel qu'illustré en figure 2.

L'étape suivante 1002 consiste à engendrer un signal représentant la différence entre le signal d'origine $d_n$ et le signal transmis filtré $y_n$, soit un signal d'erreur $e_n = d_n - y_n$. En terme vectoriel, selon la notation précédente, ce signal s'écrit : $E_{kN} = D_{kN} - Y_{kN}$.

On subdivise ensuite, à l'étape 1003, ce signal d'erreur $e_n$ en un nombre déterminé N de sous-bandes de fréquences au moyen d'une décomposition orthogonale par la mise en oeuvre de la matrice des coefficients H définie précédemment. Selon un aspect particulièrement avantageux du procédé objet de l'invention, cette décomposition est réalisée par une transformation orthogonale mise en oeuvre par un banc de filtres d'analyse d'un banc de filtres à reconstruction parfaite sans perte, tel que TFD (Transformée de Fourier Discrète) ou TCD (Transformée en Cosinus Discrète) ou ELT (pour Extended Lapped Transform) ou MLT (pour Modulated Lapped Transform).

Après décomposition de l'erreur en sous-bandes, on soumet le signal d'erreur dans chaque sous-bande à un sous-échantillonnage, par décimation dans un rapport N égal au nombre de sous-bandes de fréquence. On réalise ainsi un sous-échantillonnage critique, qui est nécessaire pour la reconstruction ultérieure parfaite sans perte du signal d'erreur à partir de ses composantes en sous-bande.

L'orthogonalité de la transformation H suivie du sous-échantillonnage assure que l'application d'un critère de minimisation sur l'erreur quadratique moyenne une fois décomposée en sous-bandes est équivalente à l'application du même critère sur l'erreur non décomposée, du fait du caractère sans perte du banc de filtres d'analyse.

L'opération de sous-échantillonnage peut consister à retenir une valeur d'échantillon sur N échantillons, chaque groupe de N échantillons constituant un bloc de rang k déterminé pour lequel une itération du processus d'adaptation est effectuée. On obtient ainsi dans chaque sous-bande un signal d'erreur sous-échantillonné $e_{i,k}$. On obtient, à l'issue de l'étape 1003, la relation vectorielle :

$$\begin{pmatrix} e_{o,k} \\ \vdots \\ e_{N-1,k} \end{pmatrix} = H.E_{kN}$$

En supposant que les signaux considérés satisfont à l'hypothèse ergodique et sont stationnaires au sens large, la propriété d'orthogonalité, mentionnée ci-dessus, notamment lors de la mise en oeuvre d'un banc de filtres d'analyse à reconstruction parfaite sans perte, implique l'équivalence des deux formulations suivantes d'un critère par bloc :

$$J_0 = E\left( \sum_{n=0}^{N-1} |e_{kN+n}|^2 \right) = E\left( \sum_{i=0}^{N-1} |e_{i,k}|^2 \right)$$

où l'opérateur $E(.)$ désigne l'espérance mathématique et $|.|$ l'opérateur module du nombre complexe.

La minimisation de l'une ou l'autre de ces deux expressions du critère $J_0$ revient, du fait de l'égalité précédente, à appliquer le même algorithme LMS par blocs classique, soit en pleine bande, soit en sous-bande pour un même critère global d'erreur.

Conformément au procédé de la présente invention, l'étape 1003 de décomposition du signal d'erreur en sous-bandes et de sous-échantillonnage est suivie d'une étape 1004 consistant à appliquer à l'ensemble des signaux d'erreur en sous-bande sous-échantillonnés une pondération spécifique par des coefficients réels positifs $\lambda_i$, i étant compris entre 0 et N-1. On obtient ainsi à l'issue de l'étape 1004 des signaux d'erreur en sous-bande sous-échantillonnés pondérés $\lambda_i.e_{i,k}$.

Par ailleurs, à l'étape 1005, on soumet également le signal numérique transmis $x_n$ à une subdivision en N sous-bandes. Ainsi, dans chaque sous-bande de rang i, la composante en sous-bande du signal numérique transmis $x_{i,n}$ vérifie la relation vectorielle :

$$\begin{pmatrix} X_{o,kN}^{t} \\ \vdots \\ X_{N-1,kN}^{t} \end{pmatrix} = H.\chi_{kN}$$

avec

$$X_{i,n}^{t} = (x_{i,n}, ..., x_{i,n-L+1}) = H_i \cdot \chi_n$$

L'étape 1006 consiste ensuite à effectuer le produit de chaque composante en sous-bande conjuguée du signal numérique transmis et du signal d'erreur en sous-bande pondéré correspondant $\lambda_i \cdot e_{i,k}$ et à additionner l'ensemble des composantes en sous-bande, et à affecter à la somme ainsi obtenue un pas d'adaptation $\mu$, ce qui fournit la fonction d'adaptation $\Delta W^*$ recherchée, c'est-à-dire la modification à apporter aux coefficients du filtre adaptatif $W^*$. Le critère d'erreur que le processus de filtrage adaptatif, objet de la présente invention, se propose de minimiser est alors de la forme :

$$J_1 = \sum_{i=0}^{N-1} \lambda_i \, E \left( |e_{i,k}|^2 \right)$$

Le choix des coefficients de pondération $\lambda_i$ est discuté ci-après.

Afin d'établir l'équation d'adaptation du processus proposé, matérialisée par l'étape 1007 sur la figure 2, on suppose en premier lieu que les coefficients $\lambda_i$ sont constants et préalablement fixés. Pour une adaptation de type LMS, on utilise l'estimation instantanée du critère, soit :

$$\hat{J}_k(W) = \sum_{i=0}^{N-1} \lambda_i \, |e_{i,k}|^2$$

Conformément à l'algorithme du gradient, on peut donc écrire (1) :

$$W^*_{(k+1)N} = W^*_{kN} - \mu \, \partial \hat{J}_k / \partial W = W^*_{kN} - \mu \sum_{i=0}^{N-1} e_{i,k} \, (\partial e_{i,k} / \partial W^*)^*$$

où $\mu$ est le pas d'adaptation mentionné ci-dessus, réel positif permettant de contrôler la vitesse de convergence de l'algorithme, et l'opérateur $(\partial/\partial.)$ désigne l'opérateur dérivée partielle.

En prenant pour chaque sous-bande de rang i considéré :

$$d_{i,k} = H_i \cdot D_{kN}$$

On obtient :

$$e_{i,k} = H_i \cdot E_{kN}$$

$$E_{kN} = D_{kN} - \chi_{kN} \cdot W_{kN}^*$$

d'où

$$e_{i,k} = H_i \cdot D_{kN} - H_i \cdot \chi_{i,kN} \cdot W_{kN}^* = d_{i,k} - X_{i,kN}^{t} \cdot W^*_{kN}$$

et donc

$$\partial e_{i,k} / \partial W^* = X_{i,kN} \cdot$$

En reportant dans l'équation (1), on obtient l'équation d'adaptation de l'algorithme de la présente invention :

$$W^{*}_{(k+1)N} = W^{*}_{kN} + \mu \sum_{i=0}^{N-1} \lambda_i . x^{*}_{i,kN} . e_{i,k}$$

soit, exprimée sour forme matricielle, la relation :

$$W^{*}_{(k+1)N} = W^{*}_{kN} + \mu (H.\chi_{kN})^{H}.\Lambda^{-2}.H.E_{kN}$$

dans laquelle $\Lambda^{-2}$ désigne la matrice diagonale des coefficients de pondération $\lambda_i$.

La valeur de la fonction d'adaptation est modifiée en conséquence, ce qui permet, par une étape 1008 d'incrémentation de k, de passer à l'itération suivante. La valeur de la fonction d'adaptation et de la fonction de transfert adaptée est maintenue pendant la durée de N échantillons successifs, période du sous-échantillonnage.

La figure 3a représente un premier mode de réalisation d'un dispositif de filtrage adaptatif mettant en oeuvre le procédé de la présente invention, dans le cas particulier où le nombre L de coefficients du filtre adaptatif est inférieur ou égal au nombre N de sous-bandes.

On peut vérifier que pour $\lambda_i$=1 pour tout i, un tel mode de réalisation du dispositif de filtrage adaptatif met en oeuvre un algorithme LMS par blocs classique.

Le dispositif représenté en figure 3a comprend un filtre adaptatif 1, avantageusement constitué d'un filtre transversal ou RIF temporel (à Réponse Impulsionnelle Finie) de fonction de transfert W* présentant une longueur L. Cette longueur est choisie de façon appropriée en fonction de l'application ; on pourra par exemple prendre L=128 ou L=1024. En sortie du filtre 1 est disposé un module additionneur-soustracteur 2 permettant de calculer la différence $e_n$ entre le signal d'origine $d_n$ et le signal $y_n$, obtenu à partir du signal numérique transmis $x_n$ par filtrage dans le filtre adaptatif 1. La sortie du module additionneur-soustracteur 2 est connectée à un banc 3 de N filtres d'analyse de fonctions de transfert respectives $H_0$, $H_i$, ..., $H_{N-1}$ et présentant chacun KN coefficients. Le banc 3 de filtres permettant de réaliser la subdivision en N sous-bandes du signal d'erreur $e_n$, est avantageusement constitué par le banc de filtres d'analyse d'un banc de filtres à reconstruction parfaite sans perte, ce qui garantit la conservation, dans les sous-bandes, de toute l'information contenue dans le signal d'erreur $e_n$. En outre, un module 3' comportant un banc de filtres similaire au banc de filtres 3 d'analyse est prévu, afin de réaliser la subdivision en N sous-bandes du signal numérique transmis $x_n$. D'une manière générale, on indique que la subdivision en sous-bandes du signal numérique transmis $x_n$ peut être effectuée soit en parallèle à la subdivision effectuée grâce au banc de filtres d'analyse 3, soit séquentiellement à partir du même banc de filtres 3, le banc de filtres du module 3' étant supprimé. En sortie du banc 3 de filtres d'analyse, est prévu un module 4 de sous-échantillonnage dans un rapport N égal au nombre de sous-bandes. Le module 4 de sous-échantillonnage peut être, dans un mode de réalisation simplifié, réduit à une routine de calcul d'une valeur sur N échantillons successifs dans le cadre d'une réalisation logicielle, ou au contraire formé d'une mémoire adressable sélectivement dans le cadre d'une réalisation matérielle, sous forme de circuit dédié. Le module 4 de sous-échantillonnage est suivi d'un module 5 de pondération. Le module de pondération 5 peut par exemple consister en une table de valeurs, parmi lesquelles N coefficients de pondération sont choisis. Ainsi, à chaque signal d'erreur en sous-bande sous-échantillonné $e_{i,k}$ peut être associé un coefficient de pondération $\lambda_i$, réel positif, de valeur déterminée. La table de valeurs peut comprendre diverses valeurs arbitraires, ces valeurs pouvant être remises à jour à chaque itération. Chaque coefficient $\lambda_i$ peut par exemple présenter une valeur approchant à chaque itération la valeur de l'énergie moyenne du signal numérique transmis en sous-bande $x_{i,n}$ et/ou du rapport signal à bruit dans chaque sous-bande considérée.

En outre, ainsi que représenté en figure 3a, les sorties du banc de filtres d'analyse du module 3' comportent avantageusement un module de conjugaison, $C_i$, $i \in [0,N-1]$ permettant de délivrer directement les composantes en sous-bande conjuguées $x_{i,n}^*$ du signal numérique transmis. Les sorties du module 5 de pondération ainsi que les sorties du module 3' sont fournies en entrée à un module multiplicateur 6, suivi d'un module sommateur 7. Le module multiplicateur 6 peut être constitué par une pluralité de multiplicateurs élémentaires $P_i$, $i \in [0,N-1]$, et délivre le produit terme à terme (produit de Schur) des signaux d'erreur en sous-bande sous-échantillonnés pondérés et des signaux numériques transmis en sous-bande.

Le module sommateur 7 reçoit l'ensemble des produits terme à terme et délivre la fonction d'adaptation $\Delta W^*$.

En ce qui concerne la variante de réalisation du dispositif selon l'invention représentée en figure 3b, le filtrage adaptatif est réalisé en sous-bande. Les mêmes éléments portent les mêmes références que celles attribuées à ces derniers dans le cas de la figure 3a.

En outre, le dispositif comprend un module de subdivision en N sous-bandes 3" auquel est associé un module de sous-échantillonnage 4", un autre module de sous-échantillonnage 4''' étant en outre associé à un autre module de subdivision en sous-bande 3'''. Les modules 3" et 4" permettent de subdiviser en sous-bande respectivement de sous-échantillonner le signal d'origine $d_n$. Il en est de même en ce qui concerne les modules 3''' et 4''' relativement au signal numérique transmis $x_n$. Le module additionneur soustracteur 2 est remplacé par un module 2' comportant une pluralité de modules additionneurs soustracteurs $AD_i$. Un module de filtrage adaptatif 1' est prévu, lequel reçoit les composantes en sous-bande sous-échantillonnées du signal numérique transmis et délivre les composantes en sous-bande du signal numérique transmis filtré $y_{i,k}$ au module additionneur soustracteur 2'. Ce dernier délivre les signaux d'erreur en sous-bande sous-échantillonnés $e_{i,k}$ au module de pondération 5.

La figure 4 représente un autre mode de réalisation d'un dispositif de filtrage adaptatif mettant en oeuvre le procédé de la présente invention, où le nombre L de coefficients du filtre adaptatif est un multiple du nombre N de sous-bandes, soit L=MN. Dans ce mode de réalisation, les éléments 1, 2, 3, 3', 4, 5 sont les mêmes que dans le mode de réalisation de la figure 3a ; leur description n'est donc pas refaite.

Le processus d'adaptation mis en oeuvre par ce mode de réalisation du dispositif de filtrage adaptatif reprend les étapes 1000 à 1005 de la figure 2. Les étapes 1006 et 1007 sont identiques mais peuvent être réalisées en mémorisant au niveau de l'étape 1005 des résultats de calcul déjà obtenus pour les M-1 blocs d'échantillons antérieurs au bloc d'échantillons courant, de la façon suivante. On multiplie comme précédemment chaque composante en sous-bande du signal numérique transmis avec la composante du signal d'erreur en sous-bande sous-échantillonné pondéré correspondant $\lambda_i.e_{i,k}$. Toutefois, les produits ainsi obtenus sont additionnés tout en étant traités sous la forme de M paquets de N coefficients, ce qu'on réalise en retardant successivement de N échantillons les composantes en sous-bande conjuguées $x_{i,n}{}^*$ du signal numérique transmis, délivrées par le module 3' précédemment décrit.

Comme représenté sur la figure 4, ces retards sont produits au moyen de M modules de retard $8_0$, ..., $8_{M-1}$ comprenant chacun N éléments de retard affecté chacun à une sous-bande. Le module 6 multiplicateur de la figure 3 est ici reproduit M fois, en $6_0$ ..., $6_{M-1}$. Le module 7 sommateur de la figure 3 est de même reproduit M fois, en $7_0$, ..., $7_{M-1}$.

L'avantage principal du procédé objet de la présente invention réside dans la pondération par les coefficients $\lambda_i$. En effet, un choix judicieux de ces coefficients permet de rendre la vitesse de convergence de l'algorithme optimale dans chaque sous-bande de fréquence. On utilise pour cela le fait que la décomposition en sous-bandes est liée aux valeurs propres de la matrice de convergence du filtre adaptatif, qui est définie par :

$$C \;=\; \sum_{i=0}^{N-1} \lambda_i R_{xixi}$$

où $R_{xixi}$ est la matrice d'auto-corrélation de taille L des signaux $x_{i,n}$ de sortie du $1^{\text{ème}}$ filtre $H_i$ du banc d'analyse. Ainsi, un choix approprié des coefficients de pondération $\lambda_i$ permet d'amener la vitesse de convergence à une même valeur optimale pour chaque sous-bande. La vitesse de convergence est déterminée par la dispersion des valeurs propres de la matrice de convergence C, définie comme le rapport de la plus grande à la plus petite valeur propre. Plus cette dispersion est proche de 1, c'est-à-dire plus les valeurs propres sont proches les unes des autres, plus la convergence est rapide. Il est bien connu que pour un algorithme LMS classique, la vitesse de convergence optimale est obtenue lorsque le pas d'adaptation est proportionnel à l'inverse de l'énergie du signal d'entrée. Dans le procédé de la présente invention, le processus d'adaptation minimise l'erreur dans chaque sous-bande de façon sensiblement indépendante, et ces erreurs peuvent être ajustées avec un pas d'adaptation différent. En ce sens, le processus d'adaptation de la présente invention se comporte comme plusieurs algorithmes LMS mis en oeuvre sensiblement séparément dans chaque sous-bande. La condition de convergence optimale se traduit donc en sous-bande par $\mu\lambda_i = 1/L\sigma_{xi}{}^2$, où $\sigma_{xi}{}^2$ désigne l'estimée de l'énergie de la composante en sous-bande $x_{i,n}$ du signal transmis. On choisit chaque coefficient de pondération $\lambda_i$ de façon à obtenir la convergence la plus rapide de façon sensiblement indépendante dans chaque sous-bande lorsque $\mu$=1. Un tel choix correspond à $\lambda_i = 1/L\sigma_{xi,n}{}^2$. L'attribution d'une valeur spécifique aux coefficients de pondération $\lambda_i$, pour chaque sous-bande, permet de rectifier l'importance relative des signaux d'erreur en sous-bande, tout signal d'erreur pour chaque sous-bande considérée, dont le niveau d'énergie est faible par rapport à une ou plusieurs autres sous-bandes, pouvant ainsi être pris en compte pour le processus d'adaptation, en l'absence de tout phénomène de masquage par les signaux d'erreur des sous-bandes dont le niveau d'énergie est supérieur. Dans le cas d'un signal transmis fortement corrélé, par exemple un bruit blanc gaussien obtenu par filtrage par un filtre de fonction de transfert 1/G(z) avec G(z) = 1-1, $6z^{-1}+0,81z^{-2}$, en prenant N=10, L-20, et pour trois types de transformations orthogonales correspondant respectivement à K-1, TCD, K-2, MLT, et K-4, ELT (c'est-à-dire des longueurs respectives de N, 2N et 4N pour les filtres du banc d'analyse), le choix précédent des coefficients $\lambda_i$ conduit à des valeurs respectives de dispersion des valeurs propres de 51,2 ; 2,7 et 2,2, alors qu'on obtient pour un algorithme LMS classique une valeur de dispersion de 1400. On constate que la vitesse de convergence du processus d'adaptation proposé, en raison inverse de ces valeurs de dispersion, comme mentionné ci-dessus, est bien meilleure pour le processus d'adaptation proposé que pour un algorithme LMS classique, et qu'elle augmente lorsque la longueur des filtres du banc d'analyse augmente.

Les courbes de la figure 5 permettent également de comparer la vitesse de convergence du processus d'adaptation objet de la présente invention à celle d'un algorithme LMS classique. Sur cette figure, on a porté le temps (en nombre d'échantillons) en abscisses du graphe et l'erreur quadratique moyenne de modélisation (en décibels) en ordonnées. Le signal d'entrée du filtre adaptatif est un bruit dit USASI (bruit stationnaire présentant en moyenne le même spectre que la parole), un bruit blanc gaussien $b_n$ ayant été superposé au signal d'origine $d_n$, le rapport signal à bruit $d_n/b_n$ étant de 40 dB. Les paramètres du filtrage adaptatif pour le processus d'adaptation objet de la présente invention, sont L=128, N=32 et K=2. La courbe en traits continus représente la décroissance de l'erreur quadratique moyenne pour le processus d'adaptation objet de la présente invention, tandis que celle en traits mixtes se rapporte à un algorithme LMS classique. On constate là encore que le processus d'adaptation proposé converge plus rapidement qu'un algorithme classique.

Un tableau comparatif ci-après indique le nombre de multiplications et d'additions de nombres réels nécessaires par échantillon de signal numérique transmis $x_n$ pour un algorithme LMS classique respectivement dans le cas d'un processus d'adaptation conforme au procédé objet de la présente invention, désigné par WSAF, mis en oeuvre dans le cas d'une transformation ELT K=2, pour L=1024, N-32 pour un même signal numérique transmis $x_n$.

| Processus | Multiplications | Additions |
|-----------|-----------------|-----------|
| LMS       | 6146            | 10240     |
| WSAF      | 1013,38         | 3725,38   |

On voit bien que le processus d'adaptation conforme à l'objet du procédé et du dispositif de filtrage selon l'invention permet l'obtention d'une simplification de la complexité de calcul et d'une augmentation de la vitesse de convergence, aucune approximation du point de vue du filtrage adaptatif ne devant être introduite afin de mettre en oeuvre le processus d'adaptation dans chaque sous-bande et en conséquence le processus d'adaptation global.

**Revendications**

1. Procédé de filtrage adaptatif d'un signal numérique transmis, constitué par une succession d'échantillons ($x_n$), cette succession d'échantillons ($x_n$) étant représentative d'un signal d'origine ($d_n$) soumis à un phénomène de distorsion après transmission par l'intermédiaire d'un canal de transmission, ledit procédé de filtrage comprenant les étapes consistant à soumettre ledit signal numérique transmis ($x_n$) à un filtrage adaptatif de fonction de transfert (W*) pour obtenir un signal numérique transmis filtré succession d'échantillons ($Y_n$), engendrer un signal d'erreur ($e_n$) pour chaque échantillon considéré, différence algébrique entre le signal numérique d'origine ($d_n$) et le signal numérique transmis filtré ($y_n$), caractérisé en ce qu'il consiste à :

   - soumettre ledit signal d'erreur ($e_n$) à une subdivision par décomposition orthogonale en un nombre déterminé (N) de sous-bandes de fréquences de largeur déterminée, pour engendrer, pour chaque sous-bande, un signal d'erreur en sous-bande ;
   - à soumettre chaque signal d'erreur en sous-bande à un sous-échantillonnage par décimation dans un rapport (N), égal au nombre de sous-bandes, pour obtenir un ensemble de signaux d'erreur en sous-bande sous-échantillonnés ($e_{i,k}$), où i désigne le rang de la sous-bande considérée, $i \in [0,N-1]$, k désignant le rang d'un bloc de N échantillons ;
   - soumettre l'ensemble des signaux d'erreur en sous-bande ($e_{i,k}$) sous-échantillonnés à une pondération spécifique de coefficient ($\lambda_i$) pour engendrer des signaux d'erreur en sous-bande pondérés sous-échantillonnés ($\lambda_i.e_{i,k}$), $\lambda_i$ désignant un réel positif, à l'exclusion de $\lambda_i=1 \ \forall$ i ;
   - soumettre en outre ledit signal numérique transmis ($x_n$) à une subdivision en un même nombre déterminé de (N) sous-bandes pour engendrer une pluralité de composantes en sous-bande ($x_{i,n}$) de signal numérique transmis ;
   - établir une fonction d'adaptation ($\Delta$W*) de la fonction de transfert (W*) du filtre adaptatif comme la somme du produit de chaque composante en sous-bande conjuguée du signal numérique transmis et du signal d'erreur en sous-bande sous-échantillonné pondéré correspondant ($\lambda_i.e_{i,k}$) affectée d'un pas d'adaptation ($\mu$), ce qui permet pour un critère global d'erreur minimale, énergie minimale des signaux d'erreur en sous-bande sous-échantillonnés pondérés, d'optimiser indépendamment la vitesse de convergence du filtre adaptatif dans chaque sous-bande et ainsi la vitesse de convergence globale du filtre adaptatif.

**2.** Procédé selon la revendication 1, caractérisé en ce que chaque coefficient de pondération ($\lambda_i$) est pris égal à une valeur déterminée, ce qui permet d'amener la vitesse de convergence dudit filtre adaptatif à une même valeur optimale pour chaque sous-bande de rang i considéré.

**3.** Procédé selon l'une quelconque des revendications 1 ou 2, caractérisé en ce que pour un filtre adaptatif de fonction de transfert ($W^*$) comportant un nombre (L) de coefficients inférieur ou égal au nombre (N) de sous-bandes, la fonction d'adaptation ($\Delta W^*$) de la fonction de transfert ($W^*$) dudit filtre adaptatif est égale à un incrément algébrique de chaque coefficient du filtre adaptatif de fonction de transfert ($W^*$).

**4.** Procédé selon l'une quelconque des revendications 1 ou 2, caractérisé en ce que pour un filtre adaptatif de fonction de transfert ($W^*$) comportant un nombre (L) de coefficients multiple du nombre (N) de sous-bandes, celui-ci consiste en outre à retarder successivement les composantes en sous-bande ($x_{i,n}$) du signal numérique transmis de (N) échantillons, ce qui permet d'engendrer des valeurs de fonction d'adaptation à partir de valeurs retardées correspondant à (M) paquets de (N) coefficients, avec M = L/N.

**5.** Procédé selon la revendication 4, caractérisé en ce que chaque coefficient ($\lambda_i$) relatif à la sous-bande de rang i est pris proportionnel à l'inverse de l'estimée d'énergie de la composante en sous-bande du signal numérique transmis ($x_{i,n}$) dans la sous-bande de fréquence de rang i.

**6.** Dispositif de filtrage adaptatif d'un signal numérique transmis, constitué par une succession d'échantillons ($x_n$), cette succession d'échantillons ($x_n$) étant représentative d'un signal d'origine ($d_n$) soumis à un phénomène de distorsion après transmission par l'intermédiaire d'un canal de transmission, comprenant au moins :

- des moyens (1) de filtrage adaptatif du signal numérique transmis ($x_n$), présentant une fonction de transfert ($W^*$) et permettant d'obtenir un signal numérique transmis filtré succession d'échantillons ($y_n$) ;
- des moyens (2) générateurs d'un signal d'erreur ($e_n$) pour chaque échantillon considéré, différence algébrique entre le signal numérique d'origine ($d_n$) et le signal numérique transmis filtré ($y_n$), caractérisé en ce qu'il comprend :
- des moyens (3, 3') de subdivision en sous-bandes du signal d'erreur ($e_n$) par décomposition orthogonale et du signal numérique transmis ($x_n$) en un nombre déterminé (N) de sous-bandes de largeur déterminée, pour engendrer pour chaque sous-bande, un signal d'erreur en sous-bande et un signal numérique transmis en sous-bande ($x_{i,n}$) où i désigne le rang de la sous-bande considérée, $i \in [0,N-1]$ ;
- des moyens (4) de sous-échantillonnage de chaque signal d'erreur en sous-bande par décimation dans un rapport (N) égal au nombre de sous-bandes, lesdits moyens de sous-échantillonnage (4) permettant d'obtenir un ensemble de signaux d'erreur en sous-bande sous-échantillonnés ($e_{i,k}$), k désignant le rang d'un bloc de N échantillons ;
- des moyens (5) de pondération à partir d'un coefficient de pondération ($\lambda_i$) desdits signaux d'erreur en sous-bande sous-échantillonnés ($e_{i,k}$) permettant d'engendrer des signaux d'erreur en sous-bande sous-échantillonnés pondérés ($\lambda_i.e_{i,k}$), $\lambda_i$ désignant un réel positif, à l'exclusion de $\lambda_i = 1 \; \forall \; i$ ;
- des moyens générateurs (6,7) d'une fonction d'adaptation ($\Delta W^*$) de la fonction de transfert ($W^*$) dudit filtre adaptatif, ladite fonction d'adaptation étant établie comme la somme du produit de chaque composante en sous-bande du signal numérique transmis et du signal d'erreur en sous-bande sous-échantillonné pondéré correspondant ($\lambda_i.e_{i,k}$) affectée d'un pas d'adaptation ($\mu$), ce qui permet pour un critère global d'erreur minimale, énergie minimale desdits signaux d'erreur en sous-bande sous-échantillonnés pondérés, d'optimiser indépendamment la vitesse de convergence du filtre adaptatif dans chaque sous-bande et ainsi la vitesse de convergence globale du filtre adaptatif.

**7.** Dispositif selon la revendication 6, caractérisé en ce que lesdits moyens (1) de filtrage adaptatif sont constitués par toute implantation d'un filtre RIF temporel de longueur L déterminée, en pleine bande ou en sous-bande.

**8.** Dispositif selon l'une des revendications 6 ou 7, caractérisé en ce que lesdits moyens (3, 3') sont constitués par un banc de filtres à reconstruction parfaite sans perte, ce banc de filtres comprenant un banc de filtres d'analyse et un banc de filtres de reconstruction, ledit banc de filtres d'analyse recevant ledit signal d'erreur ($e_n$) respectivement ledit signal numérique transmis ($x_n$) et délivrant lesdits signaux d'erreur en sous-bande respectivement lesdits signaux numériques transmis en sous-bande ($x_{i,n}$).

**9.** Dispositif selon l'une des revendications 6 à 8, caractérisé en ce que lesdits moyens (5) de pondération sont constitués par un module de pondération comprenant (N) coefficients de pondération ($\lambda_i$), à chaque signal d'erreur en sous-bande sous-échantillonné ($e_{i,k}$) étant associé un coefficient de pondération ($\lambda_i$), réel positif, de rang i correspondant et de valeur déterminée, chaque coefficient de pondération ($\lambda_i$) étant fonction de l'énergie du signal dans la sous-bande de rang i et du rapport signal à bruit dans la sous-bande de rang i correspondant.

**10.** Dispositif selon l'une des revendications 6 à 9, caractérisé en ce que lesdits moyens générateurs (6, 7) d'une fonction d'adaptation ($\Delta W^*$) de la fonction de transfert ($W^*$) dudit filtre adaptatif comprennent au moins :

- un module multiplicateur (6) permettant d'effectuer un produit terme à terme des signaux d'erreur en sous-bande sous-échantillonnés pondérés et des signaux numériques transmis en sous-bande, et délivrant un ensemble de produits terme à terme correspondant ;
- un module sommateur (7) recevant ledit ensemble de produits terme à terme et délivrant ladite fonction d'adaptation.

**Patentansprüche**

**1.** Verfahren zur adaptiven Filterung eines aus einander folgenden Proben ($x_n$) bestehenden, übertragenen digitalen Signals, wobei diese einander folgenden Proben ($x_n$) repräsentativ für ein nach Übertragung durch einen Übertragungskanal einer Verzerrungserscheinung ausgesetzten Ausgangssignal ($d_n$) sind, und das Verfahren zur Filterung die folgenden Schritte umfasst:

- das übertragene digitale Signal ($x_n$) wird einer adaptiven Filterung der Übertragungsfunktion ($W^*$) ausgesetzt, zum Erhalt eines aus einander folgenden Proben ($y_n$) bestehenden übertragenen digitalen gefilterten Signals der Probenfolge ($y_n$);

- für jede betrachtete Probe wird ein Fehlersignal ($e_n$), nämlich die algebraische Differenz zwischen dem digitalen Ausgangssignal ($d_n$) und dem übertragenen digitalen filtrierten Signal ($y_n$) erzeugt, dadurch gekennzeichnet, dass es folgende Maßnahmen umfaßt:

- das Fehlersignal ($e_n$) wird einer Unterteilung durch orthogonale Zerlegung in eine bestimmte Anzahl (N) von Unterfrequenzbändern mit einer bestimmten Breite, um für jedes Unterband ein Unterbandfehlersignal zu erzeugen;

- jedes Unterbandfehlersignal wird einer dezimierenden Unterabtastung in einem Verhältnis (N) ausgesetzt, das der Zahl von Unterbändern gleich ist, zum Erhalt eines Satzes von unterabgetasteten Unterbandfehlersignalen ($e_{i,k}$), wobei i die Ordnung des betrachteten Unterbandes, i $\in$ [0, N-1], und k die Ordnung eines Blockes von N Proben bezeichnet;

- der Satz von abgetasteten Unterbandfehlersignalen ($e_{i,k}$) wird einer spezifischen Gewichtung mit einem Koeffizient ($\lambda_i$) ausgesetzt, zur Erzeugung von gewichteten, unterabgetasteten Unterbandfehlersignalen ($\lambda_i \cdot e_{i,k}$), wobei $\lambda_i$ eine positive, reale Zahl bezeichnet, mit Ausschluß von $\lambda_i = 1 \ \forall \ i$;

- das übertragene, digitale Signal ($x_n$) wird außerdem einer Unterteilung in einer gleichen bestimmten Zahl von (N) Unterbändern ausgesetzt, zur Erzeugung einer Vielzahl von Unterbandkomponenten ($x_{i,n}$) des übertragenen digitalen Signals;

- eine Anpassungsfunktion ($\Delta W^*$) der Übertragungsfunktion ($W^*$) des adaptiven Filters wird so als Summe des Produktes jeder dem übertragenen digitalen Signal und dem abgetasteten, gewichteten entsprechenden Unterbandfehlersignal ($\lambda_i e_{i,k}$) konjugiert, mit einer Anpassungsstufe ($\mu$) angelegten Unterbandkomponente errichtet, dass für ein Gesamtkriterium von Minimalfehlem und Minimalenergie der abgetasteten, gewichteten Unterbandfehlersignale, die Konvergenzgeschwindigkeit des adaptiven Filters in jedem Unterband und damit die gesamte Konvergenzgeschwindigkeit des adaptiven Filters unabhängig optimiert werden.

**2.** Verfahren gemäß Anspruch 1, dadurch gekennzeichnet, dass jeder Gewichtskoeffizient ($\lambda_i$) mit einem bestimmten Wert gleichgesetzt wird, der es zulässt, die Konvergenzgeschwindigkeit des adaptiven Filters auf einen gleichen optimalen Wert für jedes betrachtete Unterband mit der Ordnung i zu bringen.

**3.** Verfahren gemäß jedem der Ansprüche 1 oder 2, dadurch gekennzeichnet, dass bei einem adaptiven Filter von einer Übertragungsfunktion (W*) mit einer Zahl (L), der geringer oder gleich der Zahl (N) der Koeffizienten der Unterbänder ist, die Anpassungsfunktion (ΔW*) der Übertragungsfunktion (W*) des adaptiven Filters gleich einem algebraischen Inkrement jedes Koeffizientes des adaptiven Filters von Übertragungsfunktion (W*) ist.

4. Verfahren gemäß einem der Ansprüche 1 oder 2, dadurch gekennzeichnet, dass bei einem adaptiven Filter von einer Übertragungsfunktion (W*) mit einer Zahl (L), der ein Mehrfach der Zahl (N) der Koeffizienten der Unterbänder ist, das Verfahren außerdem so die sukzessive Verzögerung der Unterbandkomponenten $(x_{i,n})$ des übertragenen digitalen Signals von (N) Proben umfasst, dass Werte der Anpassungsfunktion auf Basis von mit (M) Bündeln von (N) Koeffizienten entsprechenden Verzögerungswerten, erzeugt werden, wobei M=L/N.

5. Verfahren gemäß Anspruch 4, dadurch gekennzeichnet, dass jeder dem Unterband mit der Ordnung i entsprechende Koeffizient $(\lambda_i)$ proportional dem Inversen der geschätzten Energie des Unterbandkomponenten des übertragenen digitalen Signals $(x_{i,n})$ in dem Frequenzunterband mit der Ordnung i wird.

6. Vorrichtung zur adaptiven Filterung eines aus einander folgenden Proben $(x_n)$ bestehenden übertragenen digitalen Signals, wobei diese einander folgenden Proben $(x_n)$ repräsentativ für ein nach Übertragung durch einen Übertragungskanal einer Verzerrungserscheinung ausgesetzten Ausgangssignal $(d_n)$ sind, und die Vorrichtung zumindest die folgenden Merkmale aufweist:

- Mittel (1) zur adaptiven Filterung eines übertragenen digitalen Signals $(x_n)$, welche eine Übertragungsfunktion (W*) aufweisen und es zulassen, ein aus einander folgenden Proben $(y_n)$ bestehendes übertragenes digitales filtriertes Signal zu erhalten,

- Mittel (2), die für jede betrachtete Probe ein Fehlersignal $(e_n)$, nämlich eine algebraische Differenz zwischen dem digitalen Ausgangssignal $(d_n)$ und dem übertragenen digitalen gefilterten Signal $(y_n)$ erzeugen, dadurch gekennzeichnet, dass die Vorrichtung die folgenden Merkmale umfasst;

- Mittel (3, 3') zur Unterteilung des Fehlersignals $(e_n)$ von Unterbändern durch orthogonale Zerlegung und des übertragenen Digitalsignals $(x_{i,n})$ in eine bestimmte Anzahl (N) von Unterbändern mit einer bestimmten Breite, um für jedes Unterband ein Unterbandfehlersignal und ein ins Unterband übertragenes digitales Signal $(x_{i,n})$ zu erzeugen, wobei i die Ordnung des betrachteten Unterbandes bezeichnet, i ∈ [0,N-1];

- Mittel (4) zur Unterabtastung jedes Unterbandfehlersignals durch Dezimierung im Verhältnis (N), das der Anzahl der Unterbänder entspricht, wobei die Mittel (4) zur Unterabtastung es zulassen, einen Satz von unterabgetasteten Unterbandfehlersignalen $(e_{i,k})$ zu erzeugen, wobei k die Ordnung eines Blockes von N Proben bezeichnet;

- Mittel (5) zur Gewichtung ausgehend von einem Koeffizienten $(\lambda_i)$ der unterabgetasteten Unterbandfehlersignalen $(e_{i,k})$ zur Erzeugung von gewichteten unterabgetasteten Unterbandfehlersignalen $(\lambda_i \cdot e_{i,k})$, wobei $\lambda_i$ eine positive, reale Zahl bezeichnet, mit Ausschluss von $\lambda_i = 1 \ \forall$ i;

- Mittel (6, 7) zur Erzeugung einer Anpassungsfunktion (ΔW*) der Übertragungsfunktion (W*) des adaptiven Filters, wobei die Anpassungsfunktion als Summe des Produktes jeder Unterbandkomponente des übertragenen digitalen Signals und des entsprechend gewichteten unterabgetasteten, einer Anpassungsstufe (μ) angelegten Unterbandfehlersignals $(\lambda_i \cdot e_{i,k})$ so ermittelt wird, dass für ein Gesamtkriterium von Minimalfehler und Minimalenergie der gewichteten, unterabgetasteten Unterbandfehlersignale, die Konvergenzgeschwindigkeit des adaptiven Filters unabhängig in jedem Unterband und damit die gesamte Konvergenzgeschwindigkeit des adaptiven Filters optimiert werden.

7. Vorrichtung gemäß Anspruch 6, dadurch gekennzeichnet, dass die Mittel (1) zur adaptiven Filterung aus jeder Einrichtung eines zeitlichen RIF Filters mit einer bestimmten Länge L bestehen, entweder im kompletten Band oder im Unterband.

8. Vorrichtung gemäß einem der Ansprüche 6 oder 7, dadurch gekennzeichnet, dass die Mittel (3, 3') sich aus einem Filtersatz zur perfekten und verlustfreien Wiederherstellung zusammensetzen, wobei dieser Filtersatz einen Analyse- sowie einen Wiederherstellungsfiltersatz aufweist, wobei der Analysefiltersatz das Fehlersignal $(e_n)$ bzw. das übertragene digitale Signal $(x_n)$ empfängt und die Unterbandfehlersignale bzw. die übertragenen digitalen Unterbandsignale $(x_{i,n})$ liefert.

**9.** Vorrichtung gemäß einem der Ansprüche 6 bis 8, dadurch gekennzeichnet, dass die Mittel (5) zur Gewichtung aus einer Gewichtungseinheit bestehen, die (N) Gewichtskoeffizienten ($\lambda_i$) umfasst, wobei jedem unterabgetasteten Unterbandfehlersignal ($e_{i,k}$) als Gewichtskoeffizient ($\lambda_i$) eine positive, reale Zahl, der eine entsprechende Ordnung i und einen bestimmten Wert aufweist, zugeordnet ist, wobei jeder Gewichtskoeffizient ($\lambda_i$) eine Funktion von der Energie des Signals im Unterband mit der Ordnung i und dem Signal/Rausch-Verhältnis im Unterband mit einer entsprechenden Ordnung i ist.

**10.** Vorrichtung gemäß einem der Ansprüche 6 bis 9, dadurch gekennzeichnet, dass die Mittel (6, 7) zur Erzeugung einer Anpassungsfunktion ($\Delta W^*$) der Übertragungsfunktion ($W^*$) des adaptiven Filters zumindest die folgenden Merkmale umfassen:

- eine Multiplikationseinheit (6), die fähig ist, ein gliederweises Produkt der gewichteten, unterabgetasteten Unterbandfehlersignale und der übertragenen digitalen Unterbandsignale zu ermitteln, sowie einen entsprechenden Satz von gliederweisen Produkten zu liefern;

- eine Summeneinheit (7), die den Satz von gliederweisen Produkten empfängt und die Anpassungsfunktion liefert.

## Claims

**1.** Method for adaptive filtering of a transmitted digital signal constituted by a succession of samples ($x_n$), this succession of samples ($x_n$) being representative of a source signal ($d_n$) subjected to a distortion phenomenon after transmission through the intermediary of a transmission channel, said filtering method comprising the steps consisting in subjecting said transmitted digital signal ($x_n$) to adaptive filtering with a transfer function ($W^*$) in order to obtain a filtered transmitted digital signal in the form of a succession of samples ($Y_n$), generating an error signal ($e_n$) for each sample considered, being the algebraic difference between the source digital signal ($d_n$) and the filtered transmitted digital signal ($y_n$), characterised in that it consists in:

- subjecting said error signal ($e_n$) to subdivision by orthogonal breakdown into a given number (N) of frequency sub-bands of given width in order to generate a sub-band error signal for each sub-band;
- subjecting each sub-band error signal to sub-sampling by decimation in a ratio (N) equal to the number of sub-bands in order to obtain a set of sub-sampled sub-band error signals ($e_{i,k}$) in which i denotes the rank of the sub-band considered, $i \in [0,N-1]$, k denoting the rank of a block of N samples;
- subjecting the set of sub-sampled sub-band error signals ($e_{i,k}$) to specific weighting with a coefficient ($\lambda_i$) in order to generate sub-sampled weighted sub-band error signals ($\lambda_i.e_{i,k}$), $\lambda_i$ denoting a positive real coefficient, excluding $\lambda_i=1 \; \forall \; i$;
- additionally subjecting said transmitted digital signal ($x_n$) to subdivision into a same given number (N) of sub-bands in order to generate a plurality of transmitted digital signal sub-band components ($x_{i,n}$);
- establishing an adaptation function ($\Delta W^*$) for the transfer function ($W^*$) of the adaptive filter as the sum of the product of each conjugate sub-band component of the transmitted digital signal and of the corresponding weighted sub-sampled sub-band error signal ($\lambda_i.e_{i,k}$) to which an adaptation step ($\mu$) is applied, which, for an overall minimum error criterion, being the minimum energy of the weighted sub-sampled sub-band error signals, permits independent optimisation of the speed of convergence of the adaptive filter in each sub-band and thus of the overall speed of convergence of the adaptive filter.

**2.** Method according to claim 1, characterised in that each weighting coefficient ($\lambda_i$) is chosen equal to a given value, which makes it possible to bring the speed of convergence of said adaptive filter to a same optimum value for each sub-band of rank i considered.

**3.** Method according to one of claims 1 or 2,
characterised in that for an adaptive filter of transfer function ($W^*$) comprising a number (L) of coefficients less than or equal to the number (N) of sub-bands, the adaptation function ($\Delta W^*$) of the transfer function ($W^*$) of said adaptive filter is equal to an algebraic increment of each coefficient of the adaptive filter of transfer function ($W^*$).

**4.** Method according to one of claims 1 or 2,
characterised in that for an adaptive filter of transfer function ($W^*$) comprising a number (L) of coefficients which is a multiple of the number (N) of sub-bands, the latter also consists in successively delaying the sub-band components ($x_{i,n}$) of the transmitted digital signal of (N) samples, which makes it possible to generate adaptation function values from delayed values corresponding to (M) packets of (N) coefficients, with M = L/N.

5. Method according to claim 4, characterised in that each coefficient ($\lambda_i$) relating to the sub-band of rank i is chosen proportional to the inverse of the estimated energy of the sub-band component of the transmitted digital signal ($x_{i,n}$) in the frequency sub-band of rank i.

6. Device for adaptive filtering of a transmitted digital signal, constituted by a succession of samples ($x_n$), this succession of samples ($x_n$) being representative of a source signal ($d_n$) subjected to a distortion phenomenon after transmission through the intermediary of a transmission channel, comprising at least:

- means (1) for adaptive filtering of the transmitted digital signal ($x_n$), exhibiting a transfer function (W*) and making it possible to obtain a filtered transmitted digital signal in the form of a succession of samples ($y_n$);
- means (2) for generating an error signal ($e_n$) for each sample considered, being the algebraic difference between the source digital signal ($d_n$) and the filtered transmitted digital signal ($y_n$), characterised in that it comprises:
- means (3, 3') for subdividing the error signal ($e_n$) into sub-bands by orthogonal breakdown, and the transmitted digital signal ($x_n$) into a given number (N) of sub-bands of given width in order to generate for each sub-band a sub-band error signal and a sub-band transmitted digital signal ($x_{i,n}$) in which i denotes the rank of the sub-band considered, $i \in [0,N-1]$ ;
- means (4) for sub-sampling each sub-band error signal by decimation in a ratio (N) equal to the number of sub-bands, said means for sub-sampling (4) making it possible to obtain a set of sub-sampled sub-band error signals ($e_{i,k}$), k denoting the rank of a block of N samples;
- means (5) for weighting said sub-sampled sub-band error signals ($e_{i,k}$) from a weighting coefficient ($\lambda_i$) making it possible to generate weighted sub-sampled sub-band error signals ($\lambda_i.e_{i,k}$), $\lambda_i$ denoting a positive real coefficient, excluding $\lambda_i = 1 \; \forall \; i$;
- means (6, 7) for generating an adaptation function ($\Delta W*$) for the transfer function (W*) of said adaptive filter, said adaptation function being established as the sum of the product of each sub-band component of the transmitted digital signal and of the corresponding weighted sub-sampled sub-band error signal ($\lambda_i.e_{i,k}$) to which an adaptation step ($\mu$) is applied, which, for an overall minimum error criterion, being the minimum energy of said weighted sub-sampled sub-band error signals, allows independent optimisation of the speed of convergence of the adaptive filter in each sub-band and thus of the overall speed of convergence of the adaptive filter.

7. Device according to claim 6, characterised in that said means (1) for adaptive filtering are constituted by any full-band or sub-band installation of a time-based FIR [finite impulse response] filter of given length L.

8. Device according to one of claims 6 or 7, characterised in that said means (3, 3') are constituted by a bank of filters for perfect lossless reconstruction, this bank of filters comprising a bank of analysing filters and a bank of reconstructing filters, said bank of analysing filters receiving said error signal ($e_n$) and said transmitted digital signal ($x_n$) respectively and delivering said sub-band error signals and said sub-band transmitted digital signals ($x_{i,n}$) respectively.

9. Device according to one of claims 6 to 8, characterised in that said weighting means (5) are constituted by a weighting module comprising (N) weighting coefficients ($\lambda_i$), each sub-sampled sub-band error signal ($e_{i,k}$) having an associated positive real weighting coefficient ($\lambda_i$) of corresponding rank i and given value, each weighting coefficient ($\lambda_i$) being a function of the energy of the signal in the sub-band of rank i and of the signal to noise ratio in the sub-band of corresponding rank i.

10. Device according to one of claims 6 to 9, characterised in that said means (6, 7) for generating an adaption function ($\Delta W*$) for the transfer function (W*) of said adaptive filter comprise at least:

- a multiplication module (6) making it possible to obtain a term for term product of the weighted sub-sampled sub-band error signals and the sub-band transmitted digital signals, and delivering a corresponding set of term for term products;
- a summing module (7) receiving said set of term for term products and delivering said adaptation function.

$$x_n$$

$$y_n$$

$$e_n = d_n - y_n$$

FIG.1a.
(ART ANTERIEUR)

$$d_n + \quad e_n = d_n - y_n$$

FIG.1b.
(ART ANTERIEUR)

FIG.5.

FIG.2.

FIG.3a

FIG.3b

FIG.4